# EUROPÄISCHE PATENTANMELDUNG

(11) **EP 0 872 882 A2**
(43) Veröffentlichungstag der Anmeldung: **21.10.1998**
(21) Anmeldenummer: 98105261.6
(22) Anmeldetag: 24.03.1998
(51) Int. Cl.: H01L 21/48, H01L 23/13

(54) **Verfahren zum Herstellen eines gewölbten Metall-Keramik-Substrates**

(30) Priorität: 15.04.1997 DE 19715540
(71) Anmelder: Curamik Electronics GmbH, 92676 Eschenbach (DE)
(72) Erfinder: Schulz-Harder, Jürgen, Dr., 91207 Lauf (DE); Exel, Karl, Dr., 64668 Rimbach (DE)
(74) Vertreter: Graf, Helmut, Dipl.-Ing.

(57) **Zusammenfassung**

Die Erfindung bezieht sich auf ein neuartiges Verfahren zum Herstellen eines gewölbten Metall-Keramik-Substrates mit einer von einer Keramikplatte gebildeten Keramikschicht, die an wenigstens einer Oberflächenseite mit einer Metallisierung versehen ist, welche auf die vorgewölbte Keramikplatte aufgebracht wird.

## Beschreibung

Die Erfindung bezieht sich auf ein Verfahren zum Herstellen eines gewölbten Metall-Keramik-Substrats zur Verwendung als Substrat bei elektrischen oder elektronischen Schaltkreisen oder Bauelementen gemäß Oberbegriff Patentanspruch 1.

Bekannt ist es, die zum Herstellen von Leiterbahnen, Anschlüssen usw. benötigte Metallisierung auf einer Keramik, z.B. auf einer Aluminium-Oxid-Keramik mit Hilfe des sogenannten 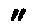 DCB-Verfahrens" (Direct-Copper-Bond-Technology) herzustellen, und zwar unter Verwendung von die Metallisierung bildenden Metall- bzw. Kupferfolien oder Metall- bzw. Kupferblechen, die an ihren Oberflächenseiten eine Schicht oder einen Überzug (Aufschmelzschicht) aus einer chemischen Verbindung aus dem Metall und einem reaktiven Gas, bevorzugt Sauerstoff aufweisen. Bei diesem beispielsweise in der US-PS 37 44 120 oder in der DE-PS 23 19 854 beschriebenen Verfahren bildet diese Schicht oder dieser Überzug (Aufschmelzschicht) ein Eutektikum mit einer Schmelztemperatur unter der Schmelztemperatur des Metalls (z.B. Kupfers), so daß durch Aufliegen der Folie auf die Keramik und durch Erhitzen sämtlicher Schichten diese miteinander verbunden werden können, und zwar durch Aufschmelzen des Metalls bzw. Kupfers im wesentlichen nur im Bereich der Aufschmelzschicht bzw. Oxidschicht.

Dieses DCB-Verfahren weist dann z.B. folgende Verfahrensschritte auf:
- Oxidieren einer Kupferfolie derart, daß sich eine gleichmäßige Kupferoxidschicht ergibt;
- Aufliegen des Kupferfolie auf die Keramikschicht;
- Erhitzen des Verbundes auf eine Prozeßtemperatur zwischen etwa 1065° bis 1085°C, z.B. auf ca. 1071°C;
Abkühlen auf Raumtemperatur.

Bekannt ist ein gewölbtes Substrat und dessen Herstellung (EP 0 279 601). Im bekannten Fall besitzt die Metallschicht an der konkav gewölbten Oberseite der Keramikschicht eine deutlich größere Dicke als die Metallschicht an der konvex gewölbten Unterseite des Substrates. Diese Ausbildung ist im bekannten Fall notwendig, da dort die Wölbung des Substrates beim Abkühlen nach dem DCB-Prozess erreicht werden soll, mit dem die beiden Metallisierungen auf der Keramikschicht bzw. Keramikplatte befestigt werden. Da die Metallisierung an der Oberseite eine größere Dicke und damit ein größeres Volumen aufweist, sind thermisch bedingte Spannungen an der Oberseite größer als an der Unterseite, so daß sich das Substrat beim Abkühlen in der vorgenannten Weise wölbt. Nachteilig ist hierbei u.a., daß dieser 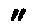 Bimetall"-Effekt reversibel ist, d.h. bei Erwärmung tritt ein Rückbiegen oder Rückwölben des Substrates ein. Bei Verwendung des bekannten Substrates für Leistungs-Bauelemente wird dann die durch die Wölbung bedingte Anpreßkraft zwischen der Unterseite des Substrates und einem Kühlkörper mit steigender Erwärmung reduziert, d.h. gerade dann, wenn zur Erzielung eines besonders geringen Wärmewiderstandes zwischen Substrat und Kühlkörper eine hohe Anpreßkraft erforderlich ist, wird diese durch das Erwärmen des Substrates reduziert. Weiterhin ist auch die Biegebruchfestigkeit des bekannten gewölbten Substrates nicht zufriedenstellend.

Aufgabe der Erfindung ist es, ein Verfahren aufzuzeigen, mit welchem gewölbte Metall-Keramiksubstrate insbesondere mit gleicher Dicke der Metallisierungen an der Oberseite und Unterseite problemlos hergestellt werden können. Zur Lösung dieser Aufgabe ist ein Verfahren entsprechend dem Patentanspruch 1 ausgebildet.

Das mit dem erfindungsgemäßen Verfahren hergestellte Metall-Keramik-Substrat ist für elektrische oder elektronische Leistungsschaltkreise oder -module geeignet und weist gegenüber bekannten gewölbten Substraten eine verbesserte, temperaturunabhängige Wärmeableitung auf.

Das erfindungsgemäße Verfahren sieht vor, zunächst aus einem planen oder im wesentlichen planen Plattenrohling eine vorgewölbte Keramikplatte herzustellen und dann auf diese vorgewölbte Keramikplatte in einem weiteren Verfahrensabschnitt die Metallisierung aufzubringen.

Durch die Krümmung des Substrates bzw. der Keramikschicht ist es möglich, dieses im Verwendungsfall elastisch derart eben zu biegen, daß das Substrat aufgrund der elastischen Spannung der Keramikschicht dicht und fest gegen eine Fläche einer Wärme ableitenden Metallplatte anliegt, und sich hierdurch eine verbesserte Wärmeableitung ergibt, insbesondere auch bei Verwendung einer Kühlpaste zwischen dem Substrat und der Metallplatte. Die Wölbung des Substrates dient also insbesondere dazu, eine optimale Anlage der Unterseite bzw. der unteren Metallisierung des Substrates an z.B. einer Metallplatte und damit einen möglichst optimalen Wärmeübergang zwischen dem Substrat und dieser beispielsweise einen Kühlkörper bildenden Metallplatte zu gewährleisten. Dieses durch die Vorkrümmung des Substrates erzielte, verbesserte Verbindung zwischen dem Substrat und der Metallplatte soll unabhängig von der jeweiligen Temperatur des Substrates bzw. der Metallplatte möglichst konstant sein. Diese Forderung ist dann nicht mehr erfüllt, wenn eine der beiden Metallschichten eine größere Dicke aufweist, da eine Metallisierung mit größerer Dicke und damit mit größerem Volumen bei Temperaturänderungen stärkere temperaturbedingte, sich ändernde Spannungen auf die betreffende Oberflächenseite der Keramikschicht ausübt. Unterschiedliche Dicken der beiden Metallisierungen auf der Oberseite und Unterseite würden somit zu einer temperaturabhängigen zusätzlichen Verwölbung des Substrates führen.

Bei dem Krümmungsgrad, welches die Erfindung vorsieht, ist auch ein Brechen der Keramikschicht mit Sicherheit vermieden.

Weiterbildungen der Erfindung sind Gegenstand der Unteransprüche. Die Erfindung wird im folgenden anhand der Figuren an einem Ausführungsbeispiel näher erläutert. Es zeigen:
- Fig. 1: in vereinfachter Darstellung und in Seitenansicht ein Substrat gemäß der Erfindung, zusammen mit einer unter dem Substrat angeordneten Metallplatte;
- Fig. 2: eine Draufsicht auf das Substrat der Fig. 1;
- Fig. 3: in vergrößerter Detaildarstellung einen Schnitt durch den in einem Gehäuse eingespannten Rand des Substrates;
- Fig. 4: in Draufsicht verschiedene Formen eines Substrates der Erfindung;
- Fig. 5: eine ähnliche Darstellung wie Fig. 3, jedoch bei einer weiteren Ausführungsform;
- Fig. 6: in vereinfachter Darstellung eine Sinter-Form zusammen mit einem Stapel aus Keramikplatten und einer auf diesem Stapel angeordneten Beschwerungsplatte beim Formen bzw. Biegen der Keramikplatten;
- Fig. 7: in vereinfachter perspektivischer Einzeldarstellung die Form bzw. Sinterplatte;
- Figuren 8 und 9: die Form im Längsschnitt (Schnittlinie I-I der Fig. 7) bzw. im Querschnitt (entsprechend der Schnittlinie II-II der Fig. 7);
- Fig. 10: in einer Darstellung ähnlich wie Fig. 6 eine weitere mögliche Ausführungsform des Formwerkzeuges;
- Fig. 11: die Sinter- oder Formplatte des Formwerkzeuges der Fig. 6 in perspektivischer Einzeldarstellung;
- Figuren 12 und 13: Schnitte entsprechend den Linien III-III bzw. IV-IV der Fig. 11.

Das in den Figuren dargestellte Substrat 1 besteht im wesentlichen aus einer Keramikschicht bzw. Keramikplatte 2, die beispielsweise eine Aluminiumoxid-Keramik ist und die an beiden Oberflächenseiten mit jeweils einer Metallisierung 3 bzw. 4 versehen ist. Die Metallisierungen 3 und 4 sind jeweils von einer Kupferfolie gebildet, die mit Hilfe der dem Fachmann bekannten DCB-Technik flächig mit der Keramikschicht 2 verbunden ist. Die Metalliesierungen besitzen die gleiche Dicke.

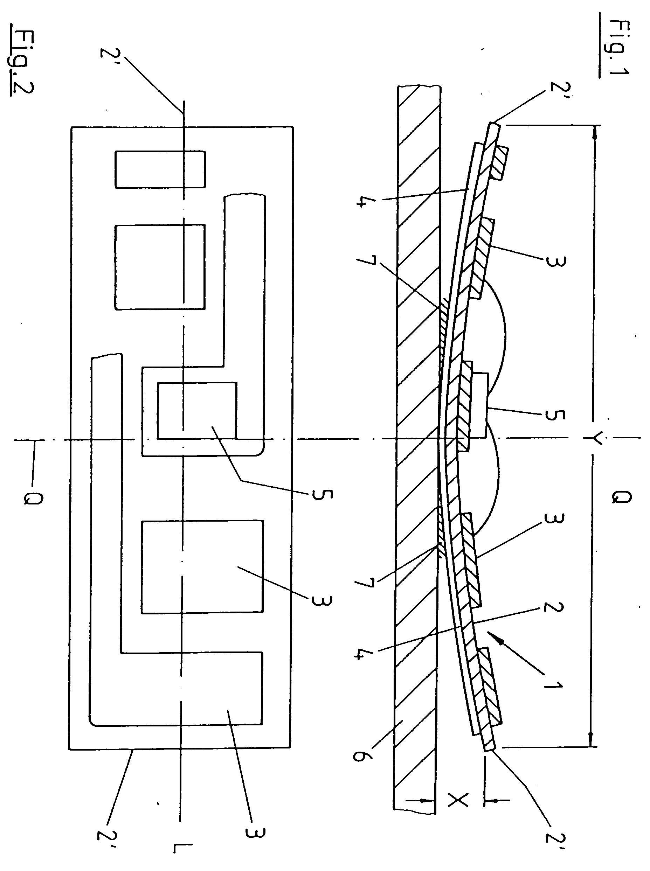

Bei der dargestellten Ausführungsform besitzt die Keramikschicht 2 in Draufsicht einen rechteckförmigen Zuschnitt mit der längeren Längsachse L und der hierzu senkrecht verlaufenden kürzeren Querachse Q. Die Keramikschicht 2 ist bei der dargestellten Ausführungsform um eine Achse parallel zur Querachse gewölbt oder gekrümmt, so daß die Oberseite der Keramikschicht 2 konkav und die Unterseite konvex ist. In gleicher Weise sind auch die dortigen Metallisierungen 3 und 4 gewölbt. Die Krümmungsachse ist in der Fig. 1 mit Q' angedeutet, besitzt aber tatsächlich einen wesentlich größeren Abstand vom Substrat 1, als in dieser Fig. gezeigt. Die Metallisierung 3 an der Oberseite ist strukturiert und bildet Leiterbahnen sowie Kontaktflächen, und zwar letztere insbesondere auch zum Befestigen, z.B. zum Auflöten von elektronischen Bauteilen 5. Die Metallisierung 4 an der Unterseite ist durchgehend ausgebildet.

Die Wölbung der Keramikschicht 2 ist derart, daß dann, wenn das Substrat mit der unteren Metallisierung 4 in der Mitte zwischen den beiden senkrecht zur Längsachse L und parallel zur Krümmungsachse Q' liegenden Querseiten 2' auf einer ebenen Fläche, beispielsweise auf der Oberseite einer ebenen Metallplatte 6 aufliegt, die Unterseite der Keramikschicht 2 an jeder Querseite 2' einen Abstand x von der Oberseite der Metallplatte 6 aufweist. Bei der dargestellten Ausführungsform ist dieser Abstand x beispielsweise etwa 0,1 - 0,8 % derjenigen Länge, die die gewölbte Keramikschicht 2 zwischen den beiden Seiten 2' besitzt, und zwar zzgl. der Dicke der unteren Metallisierung 4.

Es hat sich gezeigt, daß die thermische Leitfähigkeit zwischen dem Substrat 1 und der Metallplatte 6, die beispielsweise Bestandteil einer Wärmesenke oder eines Gehäuses ist, wesentlich verbessert werden kann. Das Substrat 1 wird auf die an ihrer Oberseite mit einer Schicht aus einer Kühlpaste 7 versehene Platte 6 aufgelegt und dann am Rand und damit auch an den Schmalseiten 2' auf die Platte 6 gedrückt, womit durch die elastische Verformung der Keramikschicht 2 ein dichtes Anliegen der unteren Metallisierung 4 an der Metallplatte 6 und ein gleichmäßiges Verteilen der Kühlpaste 7 über die gesamte von der unteren Metallsierung 4 eingenommene Fläche der Metallplatte 6 erfolgt.

Bei einer Krümmung, die im Rahmen der vorstehend genannten Grenzen liegt, ist auf jeden Fall auch sichergestellt, die Keramikschicht 2 ohne Probleme, insbesondere auch ohne die Gefahr eines Bruches in eine ebene Form zurückgebogen werden kann, und zwar auch dann, wenn die obere, an der konkaven Seite der Keramikschicht vorgesehene Metallisierung 3 strukturiert ist und somit zumindest in einem großen Teil der Oberseite der Keramikschicht keine durchgehende Metallisierung bildet, sondern in der Achsrichtung senkrecht zur Krümmungsachse nur jeweils kurze Abmessungen aufweist. Über die obere Metallisierung 3 können somit beim Rückbiegen des Substrates 1 in die ebene Form auch keine übermäßig hohen Zugkräfte zwischen der Keramikschicht 2 und der Metallisierung 3 auftreten.

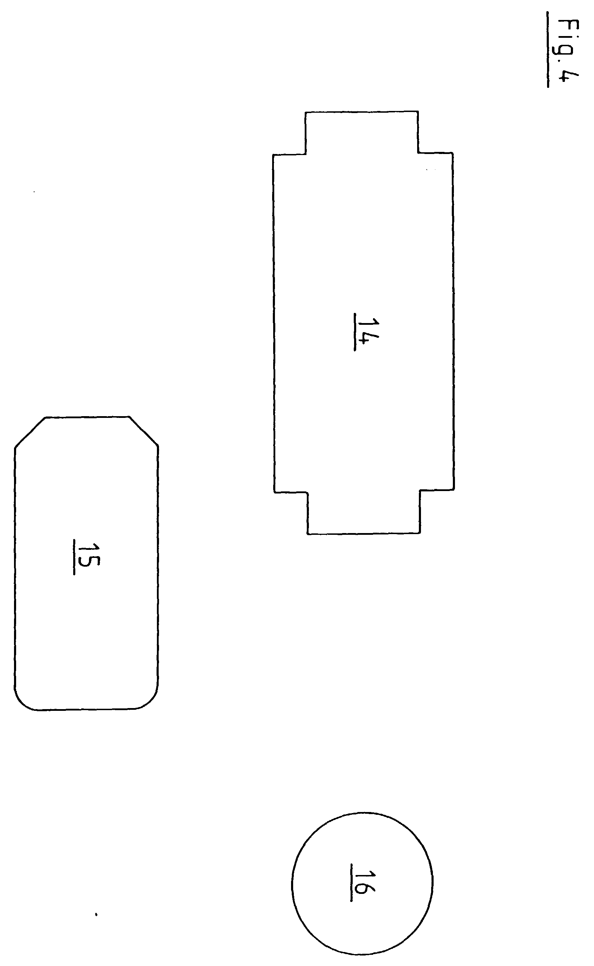

Fig. 3 zeigt die Einspannung des Substrates 1 am Rand, d.h. insbesondere auch im Bereich der beiden Schmalseiten 2' an dem einen rechteckförmigen Rahmen bildenden Teil 8 eines Gehäuses 9, mit dem das Substrat 1 dann an der den Teil der Wärmesenke bildenden Platte 6 unter Verwendung der Kühlpaste 7 befestigt werden kann. Zur Aufnahme des Randes des Substrates 1 besitzt das Gehäuseteil 8 eine falzartige Ausnehmung 10, die u.a. eine Anlagefläche 11 für die Abstützung der Oberseite der Keramikschicht 2 im Bereich des Randes bildet. Die Falz- oder Anlagefläche 11, aber auch die Unterseite 12 des Gehäuseteils 8 besitzen einen gekrümmten Verlauf, und zwar entsprechend der Wölbung des Substrates 1 bzw. der Keramikschicht 2. Der Rand bzw. die Unterseite 12 liegt auf dem gleichen Niveau mit der Unterseite der Metallisierung 4. Zwischen dem Rand der Keramikschicht 2 und der Falzfläche 11 ist eine Zwischenschicht 13 aus einer dauerelestischen Masse, vorzugsweise aus einem dauerelastischen Kleber vorgesehen. Zusätzlich zu dem vorstehend bereits beschriebenen Vorteil eines verbesserten Wärmeübergangs zwischen dem Substrat 1 und der Metallplatte 6 besteht auch der Vorteil, daß Spannungen zwischen dem Substrat 1 und dem Gehäuse 9 vermieden sind, insbesondere auch bei der Montage des Substrates 1 am Gehäuse 9. Erst beim Befestigen auf der Metallplatte 6 werden das Substrat 1 und das Gehäuse 9 elastisch verformt. Eine weitere mögliche Ausfführung ist in der Figur 5 gezeigt. Bei dieser Ausführung reicht die obere Metallisierung 3 bis an den Rand der Keramikschicht 2 und liegt damit gegen die Falzfläche 11 an.

Vorstehend wurde angenommen, daß das Substrat 1 nur um die Achse Q' gekrümmt ist. Grundsätzlich ist es aber auch möglich, das Substrat so auszuführen, daß es um zwei senkrecht zueinander verlaufende Achsen, nämlich um die Achse Q' parallel zur Querachse Q und zugleich auch um eine Achse parallel zur Längsachse L gekrümmt ist, und zwar wiederum um beide Achsen konkav an der Oberseite, so daß das Substrat beispielsweise an der Unterseite bzw. an der dortigen Metallisierung 4 eine konvex gewölbte Fläche entsprechend einer Teilfläche einer Kugeloberfläche besitzt.

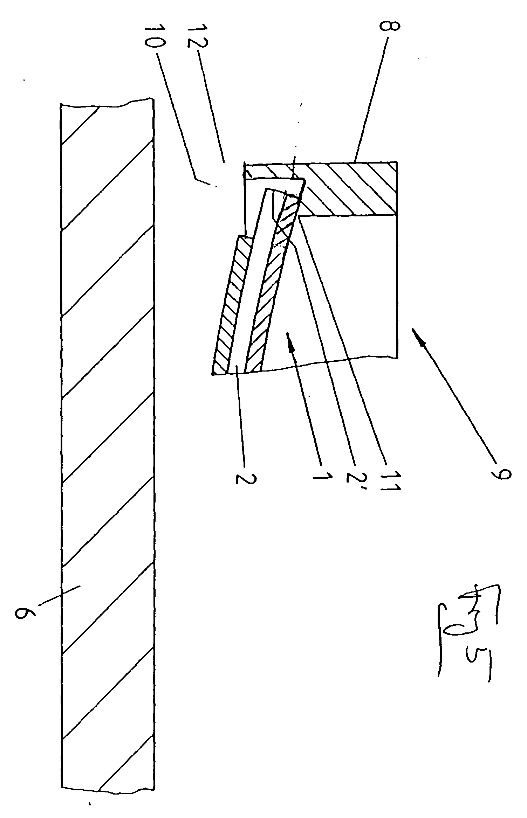

Vorstehend wurde weiterhin davon ausgegangen, daß das Substrat einen rechteckförmigen Zuschnitt, d.h. in Draufsicht eine rechteckförmige Ausbildung aufweist. Auch andere Formen sind für das Substrat denkbar, beispielsweise das in der Figur 4 wiedergegebenen Substrat 14, dessen Form sich aus einer rechteckförmigen oder quadratischen Grunform mit Vorsprüngen an zwei gegenüberliegenden Seiten zusammensetzt, oder das rechteckförmige Substrat 15 mit abgerundeten und/oder abgeschrägten Ecken und/oder das runde Substrat 16.

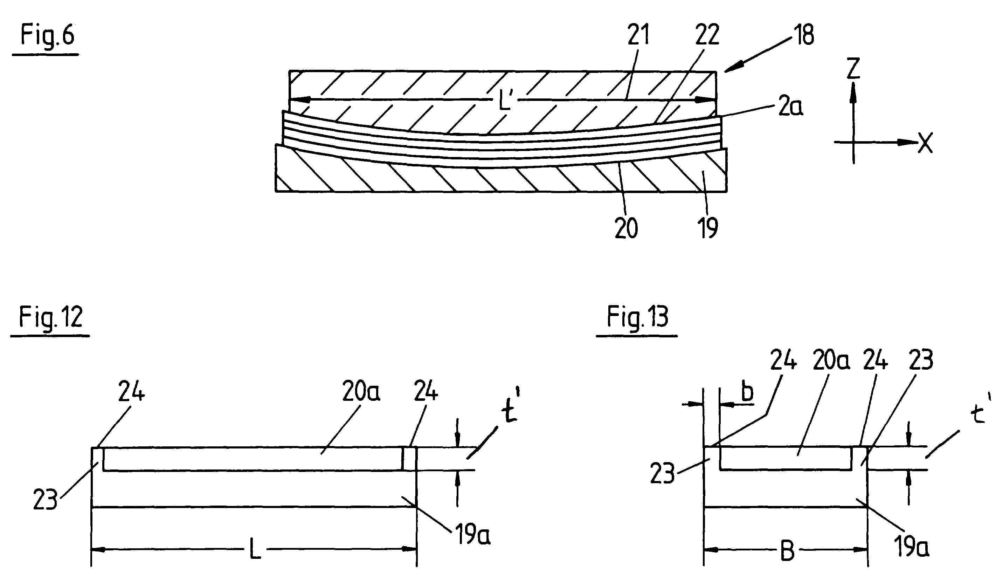

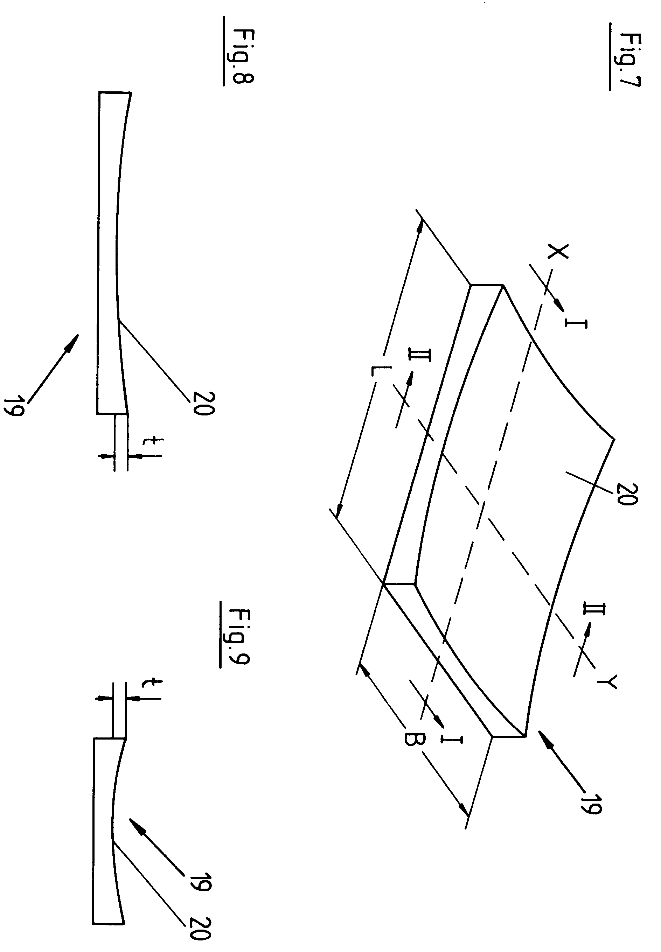

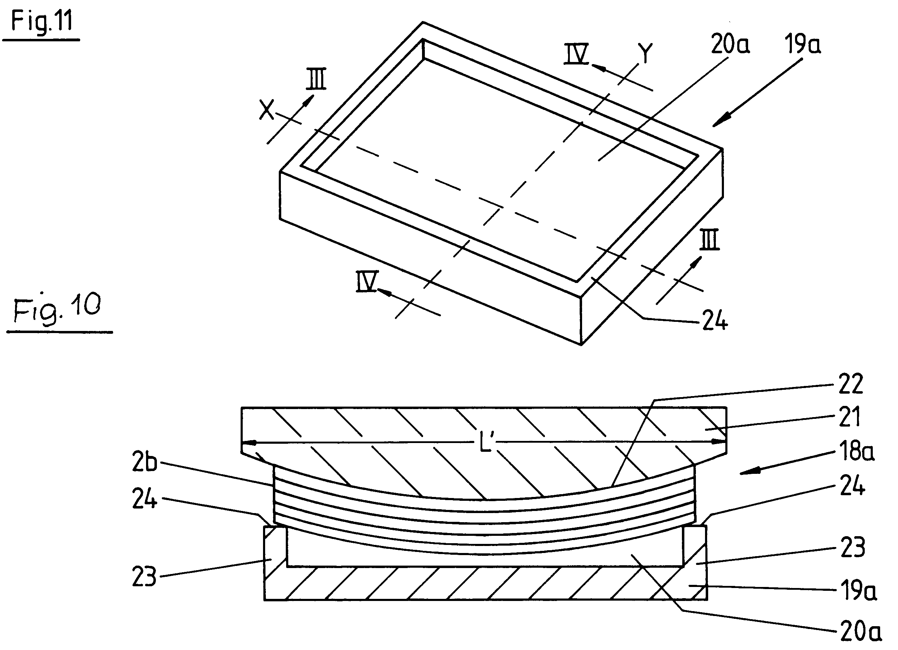

Nachstehend werden in Zusammenhang mit den Figuren 6 - 13 Verfahren und Formwerkzeuge beschrieben, mit denen das Verformen bzw. Wölben oder Krümmen der Keramikplatte 2 insbesondere auch vor dem Aufbringen der die Metallisierungen 3 und 4 bildenden Metall- bzw. Kupferfolien möglich ist.

### Beispiel: 1

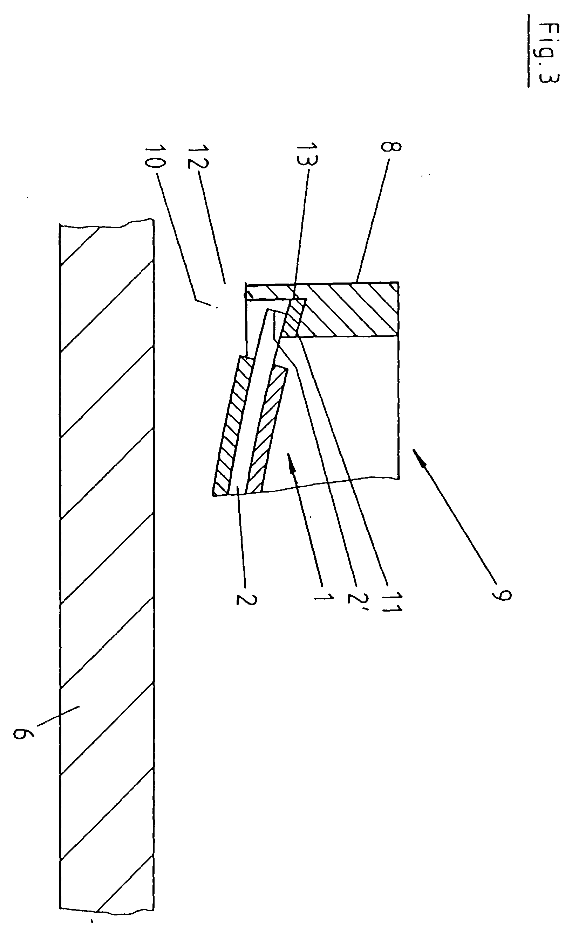

Bei dem in den Figuren 2 - 9 wiedergegebenen Beispiel wird ein Formwerkzeug 18 verwendet, welches im wesentlichen aus einer Sinter- oder Formplatte 19 aus einem hitzebeständigen Material, beispielsweise aus Siliciumkarbid (SiC) hergestellt ist und an ihrer Oberseite eine Formmulde oder -vertiefung 20 aufweist, die bei der dargestellten Ausführungsform um zwei senkrecht zueinander verlaufende Achsen, die parallel zur Längsachse und Querachse der Formplatte 19 liegen. Die Längsachse ist bei der Darstellung der Fig. 7 mit X-Achse und die Querachse mit Y-Achse bezeichnet. Die Tiefe t der Formmulde 20 in Richtung der senkrecht zur X-Achse und Y-Achse verlaufenden Z-Achse beträgt beispielsweise 0,05 - 1,5% der Breite der B oder aber der Länge L. Die Tiefe t beträgt beispielsweise 1 mm. Auf die Formplatte 19 werden mehrere Plattenrohlinge 2a aus grüner, d.h. noch nicht gebrannter Keramik aufgelegt. Zwischen den Rohlingen 2a befindet sich ein Trennpulver, z.B Korund-Pulver. Die Plattenrohlinge 2a sind beispielsweise aus einem die grüne Keramik bildenden extrudierten oder andersweitig geformten Material durch Ausstanzen hergestellt. Die Abmessungen der Rohlinge 2a sind etwas kleiner als die Abmessungen der Formplatte 19. Aufgrund des Eigengewichtes der Rohlinge liegen diese gegeneinander an und der unterste Rohling gegen die von der Formmulde 20 gebildete Fläche. Bei einer ausreichend hoher Temperatur, beispielsweise bei 1350° C werden die Rohlinge 2a dann in einer normalen Atmosphäre gesintert bzw. gebrannt, so daß nach dem Brenner gewölbte Keramikplatten 2 erhalten sind.

Die gebrannten Keramikplatten 2 werden auf Raumtemperatur langsam abgekühlt, und zwar mit einer Kühlgeschwindigkeit oder Temperaturabnahme von etwa 3° C pro Minute. Nach dem Abkühlen auf Raumtemperatur werden die einzelnen, gewölbten Keramikplatten2 dem Stapel entnommen und dann anschließend jeweils mit den Metallisierungen 3 und 4 versehen. Hierfür wird auf eine Seite jeder gewölbten Keramikschicht 2 auf eine Seite eine beispielsweise die Metallisierung 3 bildende oxidierte Kupferfolie mit einer Dicke von 0,3 mm aufgelegt. Anschließend erfolgt in einer Stickstoffatmosphäre mit einem Sauerstoffanteil von 35 ppm ein Erhitzen auf 1072° C. Die gewölbte Keramikplatte und die auf dieser dann dicht aufliegende, durch das Erhitzen weiche, aber nur im Bereich des von der Kupferoxidschicht gebildeten Eutektikums schmelzflüssigen Kupferfolie werden für etwa sechs Minuten auf der Temperatur von 1072° C gehalten. Anschließend erfolgt ein Abkühlen auf Raumtemperatur und das Aufbringen der Metallisierung auf die andere Oberflächenseite der Keramikplatte 2, beispielsweise der Metallisierung 4 in der gleichen Weise. Nach dem Aufbringen der Metallisierung 4 und dem erneuten Abkühlen erfolgt die Strukturierung wenigstens einer Metallisierung mit Hilfe einer Maskierungs- und Ätztechnik, nämlich beispielsweise der Metallisierung 3. Hierfür wird auf diese Metallisierung eine Ätzmaske aufgebracht. Anschließend erfolgt das Ätzen mit einem geeigneten Ätzmittel, beispielsweise FeCl₃. Nach dem Ätzen wird die Ätzmaske entfernt.

Die dann hergestellten Substrate besitzen Metallisierungen 3 und 4 gleicher Dicke und beispielsweise eine Durchwölbung in der Größenordnung von 0,5 - 6 mm.

Falls es erforderlich ist, wird auf den Stapel der Rohling 2a eine Beschwerplatte 21 aufgesetzt, die ebenfalls aus einem temperaturfesten Material, beispielsweise Sintermaterial, z.B. Siliciumkarbid (SiC) besteht. Die Beschwerplatte bildet an der Unterseite eine Fläche 22, deren Form der Geometrie der Formfläche der Mulde 20 entspricht. In der Fig. 6 ist diese Beschwerplatte 21 so dargestellt, daß der Längenabmessung L' etwa der Länge L der Formplatte ist, wobei auch die Breitenabmessung der Beschwerplatte 21 in etwa der Breite B der Formplatte 19 entspricht. Grundsätzlich besteht aber die Möglichkeit, daß die Länge L' und/oder die Breite B' der Beschwerplatte 21 von der Länge L bzw. der Breite B abweicht, d.h. wesentlich kleiner oder aber wesentlich größer ist. So kann die Länge L' beispielsweise im Bereich zwischen 0,2 - 200% von L betragen.

Weiterhin wurde vorstehend davon ausgegangen, daß die Fläche der Formmulde 20 gekrümmt ist. Grundsätzlich besteht aber auch die Möglichkeit, daß die Fläche von einer Vielzahl von aufeinanderfolgenden Stufen gebildet ist. Vorstehend wurde weiterhin davon ausgegangen, daß die gekrümmte bzw. gewölbte Keramikplatte 2 jeweils um zwei senkrecht zueinander verlaufende Raumachsen gewölbt ist. Es versteht sich, daß mit dem beschriebenen Verfahren selbstverständlich auch Substrate hergestellt werden können, die jeweils eine um lediglich eine Raumachse gewölbte Keramikschicht oder Keramikplatte besitzen. In diesem Fall wird ein Formwerkzeug verwendet, dessen Formmulde 20 nur um eine Achsrichtung konkav ausgeführt ist, und zwar beispielsweise als Zylinderfläche und nicht als Kalottenfläche.

Weiterhin besteht auch die Möglichkeit, das vorbeschriebene Verfahren wie folgt zu modifizieren:

Auf eine Formplatte, die nur um eine Achse konkav ausgeführt ist, wird der Stapel aus den Plattenrohlingen 2a aufgelegt und dann ggf. nach dem Beschweren mit der Beschwerplatte 21 in der vorbeschriebenen Weise bei ausreichender Temperatur gesintert bzw. vorgebrannt, beispielsweise bei einer Temperatur von etwa 1350° C. Anschließend erfolgt ein Abkühlen auf Raumtemperatur und ein Aufliegen des Stapels aus den vorgebrannten Plattenrohlingen 1' auf eine neue Formplatte, die ähnlich der Darstellung der Fig. 9 eine Formmulde 20 aufweist, die z.B. wiederum nur um eine Achse konkav ausgebildet ist. Nach dem Aufliegen der Rohlinge erfolgt dann in einem zweiten Brand bei einer Temperatur, die wenigstens um ca. 100° C unter der maximalen Temperatur des ersten Brandes liegt, ein endgültiges Brennen oder Sintern der Plattenrohlinge, die an ihrer der Formplatte abgewandten Seite dann mit der Beschwerplatte 21 beschwert sind. Es hat sich gezeigt, daß sich die vorgebrannten Plattenrohlinge 2a bei diesem zweiten Brand in die Keramikplatten 2 verformen, die um zwei senkrecht zueinander verlaufende Achsen gekrümmt sind.

Nach dem zweiten Brand erfolgt dann wiederum das Abkühlen auf Raumtemperatur und das anschließende Metallisieren der einzelnen Keramikplatten.

Die Figuren 10 - 13 zeigen ein Formwerkzeug 18a und ein mit diesem Formwerkzeug durchgeführtes Verfahren zum Herstellen von gewölbten Keramikplatten 2. Das Formwerkzeug 18a besteht aus einer Formplatte 19a sowie aus der Beschwerplatte 21. Die Formplatte 19a bildet an ihrer Oberseite die konkave Formmulde 20a, die durch eine Vertiefung realisiert ist, welche eine wesentliche konstante Tiefe t' besitzt, durch einen geschlossenen, umlaufenden Rand 23 sowie durch einen im wesentlichen ebenen Boden begrenzt ist. Die Tiefe t' beträgt wieder etwa 0,05 - 1,5% der Länge L oder Breite B. Der Rand 23 bildet bei der dargestellten Ausführungsform eine die Formmulde 20a umschließende Randfläche 24 mit einer konstanten Breite b, die etwa 0,2 - 20% Länge L oder der Breite B entspricht.

### Beispiel 2:

Zum Herstellen der gewölbten dünnen Keramikplatten 2 wird ein Stapel aus Plattenrohlingen 2b auf die Formplatte 19a derart aufgelegt, daß der unterste Rohling 2b mit seinem Umfangsrand auf dem Rand 23 aufliegt, und zwar etwa über eine Breite von 3 mm. Der Stapel enthält beispielsweise insgesamt fünfzig Rohlinge 2b, wobei jeder Rohling 2b einen rechteckförmigen Zuschnitt besitzt mit einer Länge von 150 mm und einer Breite von 100 mm. Bei den Rohlingen 2b handelt es sich um gebrannte ebene Keramikplatten (Al₂0₃ 96%).

Auf den Stapel wird die Beschwerplatte 21 aufgelegt. Anschließend wird der Stapel auf 1200° C mit einer Aufheizgeschwindigkeit von ca. 2° C/Minute erhitzt und dann etwa fünf Stunden bei 1200° C gehalten. Anschließend erfolgt ein Abkühlen auf Raumtemperatur mit einer Abkühlgeschwindigkeit von ca. 2° C/Minute. Die abgekühlten Keramikplatten besitzen dann in überraschender Weise eine Wölbung in zwei senkrecht zueinander verlaufenden Raumachsen. Nun erfolgt in weiteren Verfahrensschritten das Aufbringen der Metallisierungen 3 und 4, und zwar beispielsweise zunächst das Aufbringen der Metallisierung 3 durch Auflegen einer oxidierten Kupferfolie mit einer Dicke von 0,3 mm auf die konkav gewölbte Oberseite der jeweiligen vorgewölbten Keramikplatte 2, die dann anschließend zusammen mit dieser Kupferfolie in einer Stickstoffatmosphäre mit einem Sauerstoffanteil von ca. 35 ppm auf 1072° C erhitzt und beispielsweise für sechs Minuten auf dieser Temperatur gehalten und anschließend auf Raumtemperatur abgekühlt wird.

In einem nächsten Verfahrensschritt erfolgt in analoger Weise das Aufbringen der Metallisierung 4 unter Verwendung einer oxidierten Kupferfolie. Anschließend wird wenigstens eine der beiden Metallisierungen, beispielsweise die Metallisierung 3 mittels der Maskierungs- und Ätztechnik strukturiert, wozu eine Ätzmaske aufgebracht wird und anschließend das Ätzen mit einem geeigneten Ätzmittel, beispielsweise mit FeCl₃ erfolgt. Anschließend wird die Ätzmaske entfernt.

Dieses Verfahren kann dahingehend modifiziert werden, daß die Herstellung der gewölbten Keramikplatten 2 in zwei Schritten erfolgt, und zwar beispielsweise unter Verwendung einer Formplatte 19a, die ähnlich der Fig. 12 nur an zwei gegenüberliegenden Seiten den nach oben überstehenden Rand 23 aufweist, so daß die Rohlinge 2b in diesem ersten Schritt nur mit zwei einander gegenüberliegenden Randbereichen auf den Rändern 23 aufliegen und in dem ersten Verfahrensschritt lediglich um eine Raumachse gewölbt werden. Die Rohlinge werden dann nach dem ersten Verfahrensschritt bzw. nach der ersten Hitzebehandlung auf Raumtemperatur abgekühlt und für einen zweiten Verfahrensschritt auf eine weitere Formplatte aufgelegt, die ähnlich der Darstellung der Fig. 13 wiederum nur an zwei einander gegenüberliegenden Seiten den Rand 23 aufweist, und zwar derart, daß die Rohlinge nunmehr mit ihren beiden anderen Randbereichen auf den Rändern 23 aufliegen. Auch in dem zweiten Verfahensschritt bzw. bei der zweiten Hitzebehandlung erfolgt ein Aufheizen des Stapels aus den Rohlingen 2b auf die Temperatur von ca. 1200° C mit der Aufheizgeschwindigkeit von beispielsweise 2° C/Minute und ein Halten der Rohlinge auf der Temperatur von ca. 1200° C über eine ausreichende Zeitdauer, beispielsweise fünf Stunden und danach ein langsames Abkühlen mit einer Kühlgeschwindigkeit von ca. 2° C/Minute auf Raumtemperatur.

### Beispiel 3:

Das Aufbringen der Metallisierungen 3 und 4 kann auch auf andere Weise erfolgen, beispielweise durch Bedrucken der gewölbten Keramikplatte 2 mit einer Lötpaste, beispielsweise mit einer Lötpaste bestehend aus 40% Ag, 55% Cu und 5% Ti sowohl auf der Ober- und Unterseite der Keramikplatte 2. In einem anschließenden Verfahrensschritt erfolgt ein beidseitiges Kontaktieren der Keramikschicht mit je einer Kupferfolie mit einer Dicke von 0,3 mm und dann ein Aufheizen der gesamten Anordnung im Vakuum auf etwa 850° C und ein Halten der Anordnung über eine ausreichende Zeitdauer, beispielsweise acht Minuten bei dieser Temperatur. Anschließend erfolgt ein Abkühlen auf Raumtemperatur. Im Anschluß daran kann in der vorstehend beschriebenen Weise das Strukturieren zumindest einer Metallisierung erfolgen.

Überraschenderweise zeigt sich, daß die Substrate nach diesem Verfahren eine Durchwölbung von 0,5 - 0,6 mm besitzen.

### Beispiel 4:

Das Metallisieren kann weiterhin auch unter Verwendung einer sogenannten 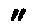 Lötfolie" erfolgen, wie sie in dem Patent DE 39 30 859 beschrieben ist. Bei dieser Lötfolie handelt es sich beispielsweise um eine dünne Kupferfolie, die beidseitig oxidiert ist und die zwischen die gewölbte Keramikplatte 2 und die der jeweiligen Metallisierung bildende Kupferfolie gelegt ist. Durch ein Erhitzen der Anordnung auf eine Temperatur beispielsweise von 1072° C und durch ein Halten der Anordnung auf dieser Temperatur über eine ausreichende Zeitspanne (z.B. sechs Minuten) erfolgt dann durch Aufschmelzen der Lötfolie ein Verbinden der Kupferfolien mit der Keramik. Die Metallisierung unter Verwendung der Lötfolie und der die Metallisierungen bildenden Kupferfolien kann hier wiederum in zwei aufeinanderfolgenden Schritten erfolgen, und zwar zunächst die eine Seite, beispielsweise zum Herstellen der Metallisierung 3, und dann für die andere Seite, beispielsweise zum Herstellen der Metallisierung 4.

Grundsätzlich besteht weiterhin die Möglichkeit, das Formwerkzeug 18 bzw. die dortige Formplatte 19 auch für die Rohlinge 2b zu verwenden.

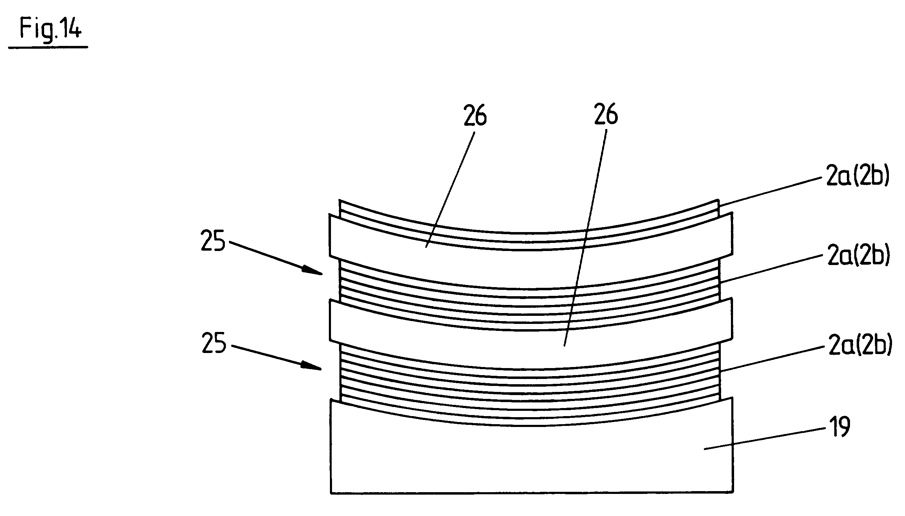

Eine weitere Möglichkeit zum Herstellen der gewölbten Keramikplatten 2 aus den Rohlingen 2a oder 2b ist in der Fig. 14 dargestellt. Dort ist eine Formplatte 19 verwendet, auf der ein erster Stapel 25 aus Rohlingen 2a oder 2b aufgebracht ist. Auf diesen ersten Stapel befindet sich eine weitere Form- oder Sinterplatte 26, die an ihrer Oberseite der Formfläche oder Formmulde der Formplatte 19 entsprechend konkav geformt ist und an ihrer Unterseite entsprechend konvex geformt ist. Auf der Formplatte 26 befindet sich ein zweiter Stapel aus Rohlingen 2a oder 2b. Auf diesem zweiten Stapel 25 ist eine zweite Formplatte 26 angeordnet, auf der sich ein dritter Stapel 25 aus Rohlingen 2a oder 2b befindet. Die Formplatten 26 bestehen wiederum aus dem hitzebeständen Material, nämlich Sintermaterial, beispielsweise Siliciumkarbid. Durch die in der Fig. 14 dargestellte Stapelanordnung kann die Anzahl der in einem Arbeitsgang hergestellten gewölbten Keramikplatten 2 wesentlich erhöht werden.

Für die Formplatte 19 bzw. 19a und die Beschwerplatte 21 eignet sich Siliziumkarbid oder ein anderes Material, welches durch die bei der Hitzebehandlung bzw. beim Brennen auftretenden Kräften und Temperaturen nicht verformbar ist.

Die Erfindung wurde voranstehend an Ausführungsbeispielen beschrieben. Es versteht sich, daß zahlreiche Änderungen sowie Abwandlungen möglich sind, ohne daß dadurch der der Erfindung zugrundeliegende Erfindungsgedanke verlassen wird.

### Bezugszeichenliste

- 1: Substrat
- 2: Keramikschicht
- 2': Querseite
- 2a, 2b: Rohling
- 3, 4: Metallisierung
- 5: Halbleiterbauelement
- 6: Metallplatte
- 7: Kühlpaste
- 8: Gehäuseteil
- 9: Gehäuse
- 10: Gehäusefalz
- 11: Falzfläche
- 12: Unterseite
- 13: dauerelestische Masse
- 14, 15, 16: Substrat
- 18, 18a: Formwerkzeug
- 19, 19a: Formplatte
- 20, 20a: Formmulde
- 21: Beschwerplatte
- 22: Fläche
- 23: Rand
- 24: Randfläche
- 25: Stapel
- 26: Formplatte
- L, Q, Q': Achse
- x: Abstand
- y: Länge

## Patentansprüche

1. Verfahren zum Herstellen eines gewölbten Metall-Keramik-Substrates für elektrische oder elektronische Bauelemente oder Schaltkreise, mit einer von einer Keramikplatte (2) gebildeten Keramikschicht, die an wenigstens einer Oberflächenseite mit einer Metallisierung (3, 4) versehen ist, welche auf die vorgewölbte Keramikplatte (2) aufgebracht wird, **dadurch gekennzeichnet**, daß ein Plattenrohling (2a, 2b) auf die mit einer Formmulde (20, 20a) versehene Oberseite eines Formelementes, beispielsweise einer Formplatte (19, 19a) aus hitzebeständigem Material aufgelegt, und im Anschluß daran während einer Hitzebehandlung auf eine Temperatur auf wenigstens 1200° C erhitzt und über eine vorgegebene Zeitdauer auf dieser Temperatur gehalten wird.

2. Verfahren nach Anspruch 1, dadurch gekennzeichnet, daß zeitlich aufeinanderfolgend zweimal eine Hitzebehandlungen des jeweiligen Plattenrohlings (2a, 2b) erfolgt, wobei beispielsweise die Temperatur bei der zweiten Hitzebehandlung um einen vorgegebenen Betrag, beispielsweise um ca. 100° C unter der Temperatur der ersten Hitzebehandlung liegt.

3. Verfahren nachAnspruch 1 oder 2, dadurch gekennzeichnet, daß die Formmulde (20) konkav gewölbt ist, beispielsweise bezogen auf zwei sich kreuzende, vorzugsweise rechtwinklig schneidende Achsen konkav ausgebildet ist.

4. Verfahren nach einem der vorhergehenden Ansprüche, dadurch gekennzeichnet, daß die Formmulde (20a) von einer Vertiefung mit einem an wenigstens zwei einander gegenüberliegenden Seiten vorgesehenen Rand (23) gebildet ist, auf dem der wenigstens eine Rohling (2a, 2b) aufliegt.

5. Verfahren nach einem der vorhergehenden Ansprüche, dadurch gekennzeichnet, daß auf die dem Formelement abgewandte Seite des wenigstens einen Rohlings (2a, 2b) ein Massegewicht (21) vorzugsweise in Form einer Beschwerplatte oder eines Gegenformelementes aufgelegt ist.

6. Verfahren nach einem der vorhergehenden Ansprüche, dadurch gekennzeichnet, daß auf das Formelement bzw. auf die Formmulde mehrere, stapelartig übereinander angeordnete Rohlinge (2a, 2b) aufgelegt werden, und zwar für eine gemeinsame Hitzebehandlung.

7. Verfahren nach einem der vorhergehenden Ansprüche, dadurch gekennzeichnet, daß auf das Formelelent (19, 19a) mehrere Stapel (25) aus jeweils mehreren Rohlingen (2a, 2b) mit dazwischenliegenden zusätzlichen Formelementen (26) aufgelegt werden, wobei die zusätzlichen Formelemente (26) an ihrer Unterseite konvex und an ihrer Oberseite konkav ausgeführt sind.

8. Verfahren nach einem der vorhergehenden Ansprüche, dadurch gekennzeichnet, daß das Aufbringen der Metallisierung unter Verwendung von die Metallisierung bildenden Metallfolien, insbesondere Kupferfolien mittels der DCB-Technik erfolgt,
wobei beispielsweise nach dem Herstellen der wenigstens einen gewölbten Keramikplatte (2) auf wenigstens eine Oberflächenseite dieser Keramikplatte eine oxidierte Kupferfolie aufgelegt und anschließend auf eine Temperatur zwischen etwa 1065 und 1085° erhitzt, eine vorgegebene Zeitperiode auf dieser Temperatur gehalten und die Anordnung anschließend auf Raumtemperatur abgekühlt wird, und/oder
wobei nach dem Aufbringen der Metallisierung mit Hilfe des DCB-Verfahrens auf die Oberflächenseite, beispielsweise auf die konkav gekrümmte Oberflächenseite und nach dem Abkühlen auf Raumtemperatur auf die andere Oberflächenseite eine weitere oxidierte Kupferfolie aufgelegt und die Anordnung anschließend erneut auf 1065 - 1085° C erhitzt und anschließend abgekühlt wird.

9. Verfahren nach einem der vorhergehenden Ansprüche, dadurch gekennzeichnet, daß zum Herstellen eines gewölbten Substrates wenigstens zwei Kupferfolien mit einer Dicke von 0,15 - 1 mm oxidiert werden, und daß die beiden Kupferfolien dann nach dem Auflegen auf jeweils eine Oberflächenseite der gewölbten Keramikplatte und durch Erhitzen auf eine Temperatur zwischen 1065 und 1085° C mittels der DCB-Technik mit der Keramik verbunden werden.

10. Verfahren nach einem der vorhergehenden Ansprüche, dadurch gekennzeichnet, daß zur Herstellung der Metallisierung an wenigstens einer Oberflächenseite der vorgewölbten Keramikplatte eine Lötpaste, vorzugsweise in Form eines Aktiv-Lotes, z.B. in der Zusammensetzung von etwa 40% Ag, 55% Cu und 5%Ti, zwischen einer Metallfolie und der Keramik vorgesehen wird, und daß anschließend die Anordnung vorzugsweise im Vakuum oder in einer Edelgas-Atmosphäre wenigstens auf die Liquidustemperatur des Lotes erhitzt wird, vorzugsweise auf etwa 750 - 1000° C,
und/oder
daß zum Herstellen der Metallisierung an wenigstens einer Oberflächenseite der vorgewölbten Keramikplatte eine Metallschicht und zwischen dieser und der Keramik eine Lötfolie, vorzugsweise in Form einer dünnen oxidierten Kupferfolie, beispielsweise mit einer Dicke von 0,15 - 1,0 mm, vorgesehen wird, und daß anschließend die Anordnung beispielsweise im Vakuum oder in einer Edelgas-Schutzatmosphäre auf eine das Aufschmelzen der Lötfolie bewirkende Temperatur, beispielsweise auf eine Temperatur von ca. 1065 - 1085° C erhitzt wird.

11. Verfahren nach einem der vorhergehenden Ansprüche, dadurch gekennzeichnet, daß die Tiefe der Formmulde etwa 0,05 - 1,5% der Breite (B) oder Länge (L) der Formmulde ist.

12. Verfahren nach einem der vorhergehenden Ansprüche, gekennzeichnet durch die Verwendung eines Rohlings (2a) aus einer Grünfolie aus nicht gebrannter Keramik,
wobei beispielsweise der wenigstens eine Plattenrohling (2a) z.B. durch Ausstanzen und Ablängen hergestellt wird und anschließend der wenigstens eine so gefertigte Plattenrohling (2a) auf das Formelement (19, 19a) aufgelegt und auf eine Sinter- oder Brenntemperatur erhitzt wird (erstes Brennen), und/oder
wobei beispielsweise nach dem ersten Brennen ein Abkühlen auf Raumtemperatur und ein anschließendes Aufliegen des wenigstens einen vorgebrannten Rohlings (2a) auf ein zweites Formelement und dann ein zweites Brennen bei einer reduzierten Temperatur, beispielsweise bei einer um ca. 100° C reduzierten Temperatur erfolgt, und/oder
wobei beispielsweise das erste Brennen bei einer Temperatur höher als 1500° C, vorzugsweise bei einer Temperatur von 1650° C erfolgt.

13. Verfahren nach einem der vorhergejemdem Ansprüche, gekennzeichnet durch die Verwendung eines Rohlings (2a) aus einer gebrannten oder vorgebrannter Keramik,
wobei vorzugsweise zur Bildung der vorgewölbten Keramikplatte der vorgebrannte Plattenrohling auf das Formelement (19, 19a) aufgelegt und dann auf eine Temperatur unterhalb der Sintertemperatur von Keramik, beispielsweise auf eine Temperatur von 1200° C aufgeheizt und eine vorgegebene Zeitdauer auf dieser Temperatur gehalten und anschließend auf Raumtemperatur abgekühlt wird, und/oder
wobei das Aufheizen auf die Behandlungstemperatur mit einer Aufheizgeschwindigkeit bzw. Temperaturzunahme von 2° C/Minute erfolgt und/oder der Rohling über eine Zeitdauer von etwa fünf Stunden auf der Behandlungstemperatur gehalten wird und/oder das Abkühlen auf Raumtemperatur mit einer Abkühlrate bzw. Temperaturreduzierung von 3° C/Minute erfolgt.

14. Verfahren nach einem der vorhergehenden Ansprüche, dadurch gekennzeichnet, daß als Formelement ein solches aus einer Sintermaterial, beispielsweise aus Siliciumkarbid (SiC) oder Gorderit verwendet wird.

15. Verfahren nach einem der vorhergehenden Ansprüche, gekennzeichnet durch die Verwendung von Rohlingen (2a, 2b) mit einer Dicke im Bereich zwischen 0,1 - 1,5 mm.

16. Verfahren nach einem der vorhergehenden Ansprüche, gekennzeichnet durch die Verwendung einer Aluminiumoxid (Al₂0₃)-Keramik oder eine Aluminiumnitrid-Keramik (AlN).

17. Verfahren nach einem der vorhergehenden Ansprüche, dadurch gekennzeichnet, daß die Metallisierung auf wenigstens einer Oberflächenseite der gewölbten Keramikplatte (2) durch Ätzen strukturiet wird.

18. Verfahren nach einem der vorhergehenden Ansprüche, dadurch gekennzeichnet, daß auf beide Oberflächenseiten der vorgewölbten Keramikplatte (2) eine Metallisierung gleicher Dicke aufgebracht wird.
